# EUROPEAN PATENT APPLICATION

(11) **EP 4 386 828 A2**
(43) Date of publication of application: **19.06.2024**
(21) Application number: 23214666.2
(22) Date of filing: 06.12.2023
(51) Int. Cl.: H01L 23/00, H01L 23/48, H01L 23/528, H01L 23/58, H01L 23/60

(54) **SEMICONDUCTOR DEVICE**

(30) Priority: 13.12.2022 KR 20220174197
(71) Applicant: Samsung Electronics Co., Ltd., Suwon-si, Gyeonggi-do 16677 (KR)
(72) Inventor: LEE, Kyoungwoo, 16677 Suwon-si (KR); LEE, Anthony Dongick, 16677 Suwon-si (KR); KIM, Kyungmin, 16677 Suwon-si (KR); KIM, Gukhee, 16677 Suwon-si (KR); KIM, Beomjin, 16677 Suwon-si (KR); KIM, Youngwoo, 16677 Suwon-si (KR); NA, Sangcheol, 16677 Suwon-si (KR); CHAE, Myeonggyoon, 16677 Suwon-si (KR); HA, Seungseok, 16677 Suwon-si (KR)
(74) Representative: Marks & Clerk LLP

(57) **Abstract**

A semiconductor device includes a semiconductor substrate having a first surface and a second surface facing away from the first surface and including, in a plan view, a main chip region and a sealing region surrounding the main chip region, a front wiring layer on the first surface of the semiconductor substrate and including a front wiring structure, a back wiring layer on the second surface of the semiconductor substrate and including a power wiring structure, a front ring structure in the front wiring layer of the sealing region, and a back ring structure in the back wiring layer of the sealing region.

## Description

### TECHNICAL FIELD

The inventive concepts relate to semiconductor devices, and more particularly, to semiconductor devices including a ring structure surrounding a main chip region.

### BACKGROUND

Semiconductor devices are generally manufactured through a die sawing process that cuts a wafer having integrated circuit devices formed therein. During the die sawing process, a sawing blade cuts the wafer along a scribe lane region such that a plurality of semiconductor devices are physically separated from each other. In such semiconductor devices, a ring structure, such as a guard ring or a moisture barrier ring, is arranged in a sealing region around a main chip region including an integrated circuit device, in order to protect the integrated circuit device from moisture or cracks that may occur during the die sawing process.

### SUMMARY

The inventive concepts provide semiconductor devices having increased reliability.

According to some aspects of the inventive concepts, there is provided a semiconductor device. The semiconductor device includes a semiconductor substrate having a first surface and a second surface facing away from the first surface and including, in a plan view, a main chip region and a sealing region surrounding the main chip region, a front wiring layer on the first surface of the semiconductor substrate and including a front wiring structure, a back wiring layer on the second surface of the semiconductor substrate and including a power wiring structure, a front ring structure in the front wiring layer of the sealing region, and a back ring structure in the back wiring layer of the sealing region.

According to some aspects of the inventive concepts, there is provided a semiconductor device. The semiconductor device includes a semiconductor substrate having a first surface and a second surface facing away from the first surface and including, in a plan view, a main chip region and a sealing region surrounding the main chip region, a front wiring layer on the first surface of the semiconductor substrate and including a front wiring structure in the main chip region, a back wiring layer on the second surface of the semiconductor substrate and including a power wiring structure in the main chip region, a front ring structure in the front wiring layer of the sealing region, and a back ring structure in the back wiring layer of the sealing region, wherein the front ring structure includes, in a plan view, a front inner ring structure surrounding the main chip region and a front outer ring structure surrounding the front inner ring structure, and the back ring structure includes, in a plan view, a back inner ring structure surrounding the main chip region and a back outer ring structure surrounding the back inner ring structure.

According to some aspects of the inventive concepts, there is provided a semiconductor device. The semiconductor device includes a semiconductor substrate having a first surface and a second surface facing away from the first surface and including, in a plan view, a main chip region and a sealing region surrounding the main chip region, a front wiring layer on the first surface of the semiconductor substrate and including a front wiring structure in the main chip region and a front insulating layer covering the front wiring structure, a back wiring layer on the second surface of the semiconductor substrate and including a power wiring structure in the main chip region and a back insulating layer covering the power wiring structure, a power through via passing through the semiconductor substrate in a vertical direction, the power through via being configured to connect the front wiring structure to the power wiring structure, a front ring structure in the front wiring layer of the sealing region and including, in a plan view, a front inner ring structure surrounding the main chip region and a front outer ring structure surrounding the front inner ring structure, and a back ring structure in the back wiring layer of the sealing region and including, in a plan view, a back inner ring structure surrounding the main chip region and a back outer ring structure surrounding the back inner ring structure.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a schematic plan view of a wafer including a semiconductor device, according to some example embodiments;
FIG. 2 is an enlarged plan view of a region AA of the semiconductor device in FIG. 1;
FIG. 3 is a schematic, vertical cross-sectional view of a semiconductor device, taken along line A-A' in FIG. 2;
FIG. 4 is a vertical cross-sectional view illustrating a state, in which a wafer is cut to manufacture a semiconductor device, according to some example embodiments;
FIG. 5 is a schematic cross-sectional view of a semiconductor device having the plan view of FIG. 2, according to some example embodiments, and is a vertical cross-sectional view illustrating a portion corresponding to FIG. 3;
FIG. 6 is a schematic cross-sectional view of a semiconductor device having the plan view of FIG. 2, according to some example embodiments, and is a vertical cross-sectional view illustrating a portion corresponding to FIG. 3;
FIG. 7 is a schematic cross-sectional view of a semiconductor device having the plan view of FIG. 2, according to some example embodiments, and is a vertical cross-sectional view illustrating a portion corresponding to FIG. 3;
FIG. 8 is a schematic cross-sectional view of a semiconductor device having the plan view of FIG. 2, according to some example embodiments, and is a vertical cross-sectional view illustrating a portion corresponding to FIG. 3; and
FIG. 9 is a schematic cross-sectional view of a semiconductor device having the plan view of FIG. 2, according to some example embodiments, and is a vertical cross-sectional view illustrating a portion corresponding to FIG. 3.

### DETAILED DESCRIPTION

Hereinafter, example embodiments are described in detail with reference to the accompanying drawings. In the drawings, like reference characters denote like elements, and redundant descriptions thereof will be omitted.

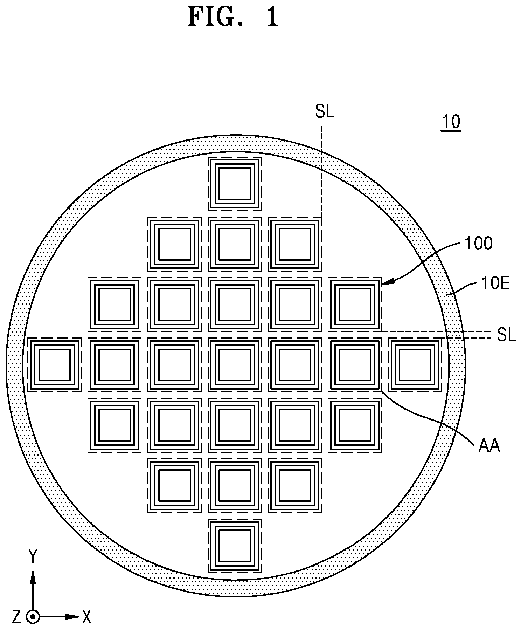

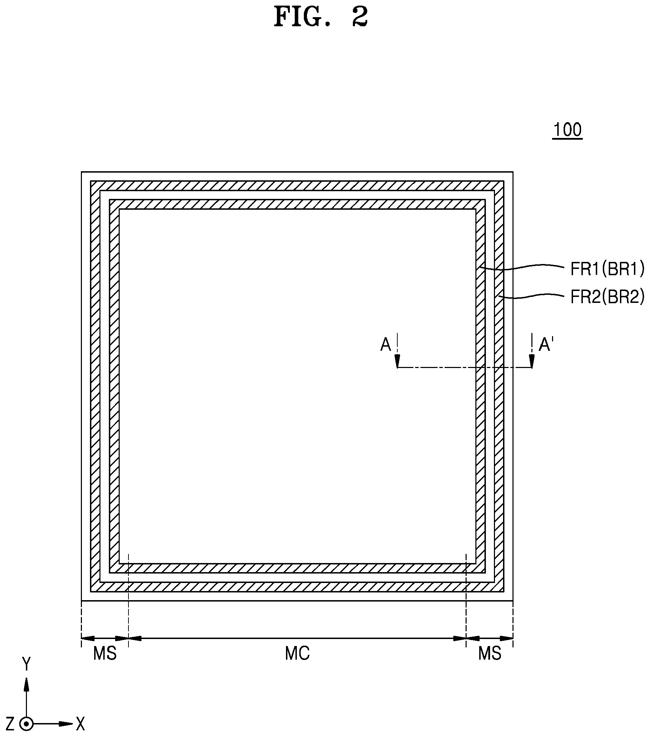

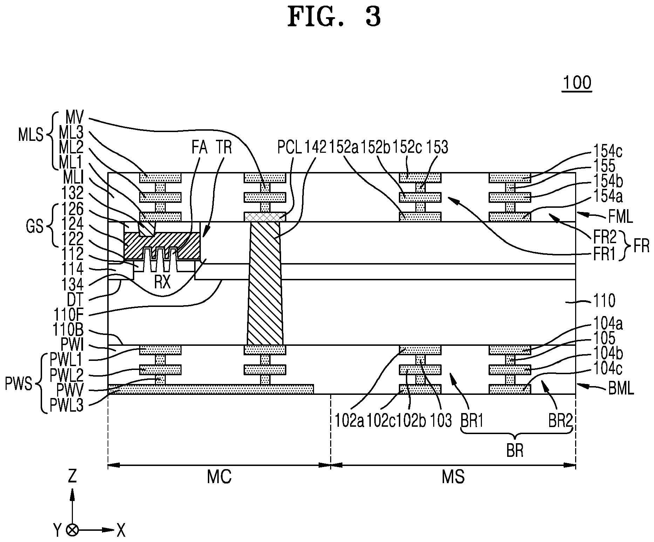

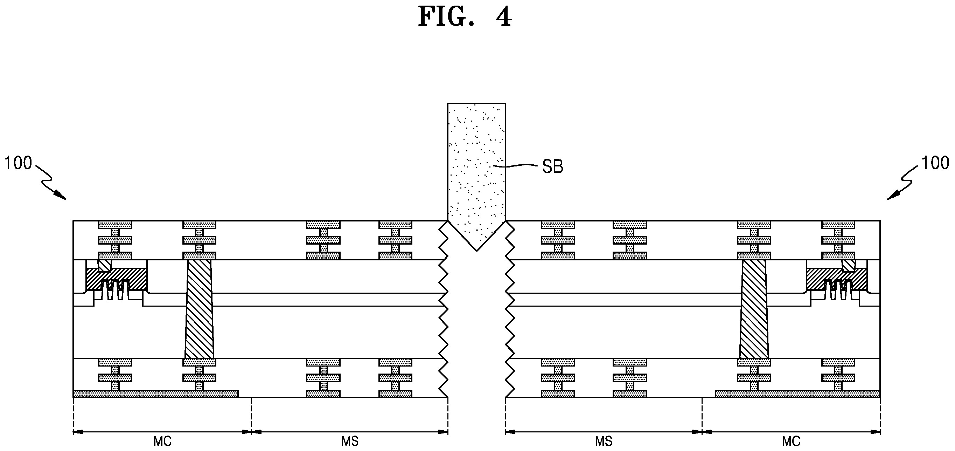

FIG. 1 is a schematic plan view of a wafer 10 including a semiconductor device 100, according to some example embodiments. FIG. 2 is an enlarged plan view of a region AA of the semiconductor device 100 in FIG. 1. FIG. 3 is a schematic, vertical cross-sectional view of the semiconductor device 100, taken along line A-A' in FIG. 2. FIG. 4 is a vertical cross-sectional view illustrating a state, in which a wafer is cut to manufacture the semiconductor device 100, according to some example embodiments.

Referring to FIGS. 1 to 4, in a plan view, the wafer 10 may include a plurality of semiconductor devices 100 surrounded by an edge region 10E thereof. According to some example embodiments, the semiconductor devices 100 may be separated by a scribe lane region SL from each other. According to some example embodiments, the scribe lane region SL may have a straight lane shape with a constant width, extend in a horizontal direction (e.g., the X direction and/or the Y direction), and separate the semiconductor devices 100 from one another. A horizontal direction may be a direction that is parallel to an upper surface of the semiconductor substrate. Similarly, a vertical direction may be a direction that is perpendicular to an upper surface of the semiconductor substrate. It will be appreciated that these directions are relative to the structure of the semiconductor devices 100, and need not imply any particular orientation of the semiconductor devices 100, in use.

According to some example embodiments, the wafer 10 may be physically divided into semiconductor chips by a die sawing process performed along the scribe lane region SL. For example, the wafer 10 may be cut along the scribe lane region SL by using a sawing blade SB in a die sawing process and thus be divided into the semiconductor devices 100.

According to some example embodiments, each of the semiconductor devices 100 may correspond to a system-on-chip (SoC). For example, each of the semiconductor devices 100 may include a mobile SoC, an application processor, a media processor, a microprocessor, a central processing unit (CPU), or the like.

A semiconductor device 100 according to the inventive concepts are described in detail below. For convenience of description, only some elements of the semiconductor device 100 are illustrated in the drawings, but one of ordinary skill in the art will be able to fully understand the remaining elements not shown.

According to some example embodiments, the semiconductor device 100 may include a semiconductor substrate 110 having a first surface 110F and a second surface 110B facing away from the first surface 110F, a front wiring layer FML on the first surface 110F of the semiconductor substrate 110, and a back wiring layer BML on the second surface 110B of the semiconductor substrate 110. The first surface 110F may also be termed a "front surface". The second surface 110B may also be termed a "back surface". The first surface 110F may be opposite the second surface 110B. In the present context, "front" and "back" refer to relative positions (e.g. along the vertical direction), but need not imply any particular orientation of the semiconductor device 100 in use.

According to some example embodiments, the semiconductor substrate 110 may include a semiconductor material, e.g., silicon (Si). The semiconductor substrate 110 may include a semiconductor element, e.g., germanium (Ge), and/or a compound semiconductor, such as silicon carbide (SiC), gallium arsenide (GaAs), indium arsenide (InAs), and/or indium phosphide (InP). In some example embodiments, the semiconductor substrate 110 may have a silicon-on-insulator (SOI) structure. According to some example embodiments, the semiconductor substrate 110 may include a conductive region, e.g., an impurity-doped well or an impurity-doped structure.

According to some example embodiments, in a plan view, the semiconductor substrate 110 may include a main chip region MC, in which an integrated circuit device TR including a gate structure GS is arranged, and a sealing region MS surrounding the main chip region MC. For example, the main chip region MC may be separated by the sealing region MS from the scribe lane region SL. Here, the main chip region MC and the sealing region MS may be equally defined not only in the semiconductor substrate 110 but also in the front wiring layer FML and the back wiring layer BML, which overlap with the semiconductor substrate 110. Furthermore, the main chip region MC and the sealing region MS may also be defined in the semiconductor device 100 in a plan view.

According to some example embodiments, the integrated circuit device TR may include a memory device and/or a logic device. For example, the integrated circuit device TR may include a fin field-effect transistor (FinFET) device. However, the inventive concepts are not limited thereto. The integrated circuit device TR may include a planar FET device, a gate-all-around FET device, a multi-bridge channel FET (MBCFET) device, or a two-dimensional (2D) material-based FET device like a MoS₂ semiconductor gate electrode.

According to some example embodiments, an active region RX may be defined by a deep trench DT in the first surface 110F of the semiconductor substrate 110. According to some example embodiments, the deep trench DT may be filled with a deep trench isolation film 114. According to some example embodiments, the active region RX of the semiconductor substrate 110 may include a plurality of fin-type active regions FA that protrude from the first surface 110F of the semiconductor substrate 110. An isolation film 112 may be between the fin-type active regions FA and cover a lower side wall of each of the fin-type active regions FA. According to some example embodiments, each of the deep trench isolation film 114 and the isolation film 112 may include an insulating material, such as silicon oxide, silicon nitride, or silicon oxynitride.

According to some example embodiments, the gate structure GS may be on the fin-type active regions FA. According to some example embodiments, the gate structure GS may include a gate dielectric film 122, a gate electrode 124, and a gate capping layer 126. According to some example embodiments, the gate dielectric film 122 may be between the gate electrode 124 and the fin-type active regions FA, and the gate capping layer 126 may be on the gate electrode 124 to cover the top surface of the gate electrode 124. According to some example embodiments, the gate dielectric film 122 may include a silicon oxide film, a silicon oxynitride film, a high-k dielectric film (e.g. a film having a higher dielectric constant than that of a silicon oxide film), or a combination thereof. The high-k dielectric film may include metal oxide and/or metal oxynitride. For example, the high-k dielectric film that may be used as the gate dielectric film 122 may include HfO₂, HfSiO, HfSiON, HfTaO, HfTiO, HfZrO, ZrO₂, Al₂O₃, or a combination thereof but is not limited thereto. According to some example embodiments, the gate electrode 124 may include Al, Cu, Ti, Ta, W, Mo, TaN, NiSi, CoSi, TiN, WN, TiAl, TiAlN, TaCN, TaC, TaSiN, or a combination thereof but is not limited thereto. According to some example embodiments, the gate capping layer 126 may include silicon nitride and/or silicon oxynitride.

According to some example embodiments, a side wall of the gate structure GS may be covered with a gate isolation insulating layer 134. According to some example embodiments, the gate isolation insulating layer 134 may include an insulating material, such as silicon oxide, silicon nitride, and/or silicon oxynitride.

According to some example embodiments, the front wiring layer FML may be on the first surface 110F of the semiconductor substrate 110 to cover the top surface of the gate capping layer 126 and the top surface of the gate isolation insulating layer 134. According to some example embodiments, the front wiring layer FML may include a front wiring structure MLS in the main chip region MC and a front insulating structure MLI covering the front wiring structure MLS. According to some example embodiments, the front wiring structure MLS may include a first front wiring layer ML1, a second front wiring layer ML2, and a third front wiring layer ML3, which are sequentially stacked in a direction away from the first surface 110F of the semiconductor substrate 110, and a front via MV. According to some example embodiments, the first to third front wiring layers ML1, ML2, and ML3 may extend in the main chip region MC in the horizontal direction (the X direction and/or the Y direction). According to some example embodiments, the front via MV may extend in a vertical direction (the Z direction) and connect the first front wiring layer ML1 to the second front wiring layer ML2 and the second front wiring layer ML2 to the third front wiring layer ML3.

According to some example embodiments, the first to third front wiring layers ML1, ML2, and ML3 and the front via MV may include W, Co, Cu, Ru, Mn, Ti, Ta, TiN, TaN, or a combination thereof but are not limited thereto. According to some example embodiments, the front insulating structure MLI may include a plurality of insulating layers stacked on each other. Each of the insulating layers may include silicon carbide (SiC), SiN, nitrogen-doped SiC (SiC:N), SiOC, AlN, AlON, AlO, AlOC, a tetraethylorthosilicate (TEOS) film, a high density plasma (HDP) film, a boro-phospho-silicate glass (BPSG) film, a flowable chemical vapor deposition (FCVD) oxide film, an SiON film, a SiN film, an SiOC film, an SiCOH film, or a combination thereof but is not limited thereto.

According to some example embodiments, the front wiring structure MLS may be on the gate structure GS and connected to the gate electrode 124 by a gate contact 132 passing through the gate capping layer 126. For example, the bottom surface of the gate contact 132 may be in contact with the gate electrode 124, and the top surface of the gate contact 132 may be in contact with the front wiring structure MLS. According to some example embodiments, the gate contact 132 may include W, Co, Cu, Ru, Mn, Ti, Ta, TiN, TaN, or a combination thereof.

According to some example embodiments, the back wiring layer BML may be on the second surface 110B of the semiconductor substrate 110. According to some example embodiments, the back wiring layer BML may include a power wiring structure PWS in the main chip region MC and a back insulating structure PWI covering the power wiring structure PWS. According to some example embodiments, the power wiring structure PWS may include a first back wiring layer PWL1, a second back wiring layer PWL2, and a third back wiring layer PWL3, which are sequentially stacked in a direction away from the second surface 110B of the semiconductor substrate 110, and a back via PWV. According to some example embodiments, the first to third back wiring layers PWL1, PWL2, and PWL3 may extend in the main chip region MC in the horizontal direction (the X direction and/or the Y direction). According to some example embodiments, the back via PWV may extend in the vertical direction (the Z direction) and connect the first back wiring layer PWL1 to the second back wiring layer PWL2 and the second back wiring layer PWL2 to the third back wiring layer PWL3. According to some example embodiments, the third back wiring layer PWL3 may have a unidirectional wiring structure, which extends long in a first horizontal direction (the X direction), but is not limited thereto.

According to some example embodiments, the power wiring structure PWS may include Co, W, Cu, Ru, Mn, Ti, Ta, TiN, TaN, or a combination thereof but is not limited thereto. According to some example embodiments, the back insulating structure PWI may include a plurality of insulating layers stacked on each other. Each of the insulating layers may include SiC, SiN, SiC:N, SiOC, AlN, AlON, AlO, AlOC, a TEOS film, an HDP film, a BPSG film, an FCVD oxide film, an SiON film, an SiN film, an SiOC film, an SiCOH film, or a combination thereof but is not limited thereto.

According to some example embodiments, the power wiring structure PWS may include a power delivery network configured to apply a power supply voltage and a ground voltage. According to some example embodiments, a power through via 142 may be in the main chip region MC and may pass through the semiconductor substrate 110, the deep trench isolation film 114, and the gate isolation insulating layer 134. According to some example embodiments, the front wiring structure MLS and the power wiring structure PWS may be connected to each other by the power through via 142. According to some example embodiments, the front wiring structure MLS may include a power connection conductive layer PCL, which is on and connected to the power through via 142. For example, the bottom surface of the power through via 142 may be in contact with the power wiring structure PWS. For example, the top surface of the power through via 142 may be in contact with the power connection conductive layer PCL of the front wiring structure MLS. For example, a power supply voltage may be applied from the power wiring structure PWS to the integrated circuit device TR through the power through via 142 and the front wiring structure MLS. According to some example embodiments, the power through via 142 may include Co, W, Cu, Ru, Mn, Ti, Ta, TiN, TaN, or a combination thereof but is not limited thereto.

Although it is illustrated in FIG. 3 that each of the front wiring structure MLS and the power wiring structure PWS includes three wiring layers, example embodiments are not limited thereto. For example, each of the front wiring structure MLS and the power wiring structure PWS may include two wiring layers or four or more wiring layers.

According to some example embodiments, in the sealing region MS, a front ring structure FR may be arranged in the front wiring layer FML and covered with the front insulating structure MLI. According to some example embodiments, in a plan view, the front ring structure FR may surround the front wiring structure MLS of the main chip region MC. The front ring structure FR may surround the front wiring structure MLS in the horizontal plane.

According to some example embodiments, in a plan view, the front ring structure FR may include a front inner ring structure FR1 surrounding the main chip region MC and a front outer ring structure FR2 surrounding the front inner ring structure FR1. The front outer ring structure FR2 may surround the front inner ring structure FR1 in the horizontal plane. In the present context "inner" and "outer" may relate to relative positions (e.g. horizontal positions relative to the main chip region MC).

According to some example embodiments, the front inner ring structure FR1 may include first to third front inner wires 152a, 152b, and 152c, which are sequentially stacked in a direction away from the first surface 110F of the semiconductor substrate 110, and a front inner via 153. According to some example embodiments, the first to third front inner wires 152a, 152b, and 152c may extend in the horizontal direction (the X direction and/or the Y direction) to surround the main chip region MC. According to some example embodiments, the front inner via 153 may extend in the vertical direction (the Z direction) and connect the first front inner wire 152a to the second front inner wire 152b and the second front inner wire 152b to the third front inner wire 152c.

According to some example embodiments, the front outer ring structure FR2 may include first to third front outer wires 154a, 154b, and 154c, which are sequentially stacked in a direction away from the first surface 110F of the semiconductor substrate 110, and a front outer via 155. According to some example embodiments, the first to third front outer wires 154a, 154b, and 154c may extend in the horizontal direction (the X direction and/or the Y direction) to surround the front inner ring structure FR1. According to some example embodiments, the front outer via 155 may extend in the vertical direction (the Z direction) and connect the first front outer wire 154a to the second front outer wire 154b and the second front outer wire 154b to the third front outer wire 154c.

In some example embodiments, each of the first to third front inner wires 152a, 152b, and 152c may be coplanar or substantially coplanar with a corresponding front outer wire among the first to third front outer wires 154a, 154b, and 154c, and a corresponding front wiring layer among the first to third front wiring layers ML1, ML2, and ML3.

In some example embodiments, the front ring structure FR may be formed together with the front wiring structure MLS in a process of forming the front wiring structure MLS in the main chip region MC. Accordingly, the front ring structure FR may be formed by an existing semiconductor manufacturing process that forms the front wiring structure MLS, without introducing an additional process.

According to some example embodiments, the front ring structure FR may include Co, W, Cu, Ru, Mn, Ti, Ta, TiN, TaN, or a combination thereof but is not limited thereto.

According to some example embodiments, in a plan view, the front inner ring structure FR1 and the front outer ring structure FR2 may respectively have concentric closed loop shapes. According to some example embodiments, the front inner ring structure FR1 and the front outer ring structure FR2 may be separated by the front insulating structure MLI from each other in the horizontal direction (the X direction and/or the Y direction).

According to some example embodiments, the front ring structure FR may be arranged in a front side of the semiconductor device 100 to protect the main chip region MC from external factors occurring during a die sawing process. For example, the front inner ring structure FR1 may prevent or reduce a crack occurring in a die sawing process from propagating to the main chip region MC, and the front outer ring structure FR2 may prevent or reduce external moisture from penetrating into the main chip region MC in the die sawing process.

According to some example embodiments, in the sealing region MS, a back ring structure BR may be arranged in the back wiring layer BML and covered with the back insulating structure PWI. According to some example embodiments, in a plan view, the back ring structure BR may surround the power wiring structure PWS of the main chip region MC. The back ring structure BR may surround the power wiring structure PWS in the horizontal plane.

According to some example embodiments, in a plan view, the back ring structure BR may include a back inner ring structure BR1 surrounding the main chip region MC and a back outer ring structure BR2 surrounding the back inner ring structure BR1. The back outer ring structure BR2 may surround the back inner ring structure BR1 in the horizontal plane.

According to some example embodiments, the back inner ring structure BR1 may include first to third back inner wires 102a, 102b, and 102c, which are sequentially stacked in a direction away from the second surface 110B of the semiconductor substrate 110, and a back inner via 103. According to some example embodiments, the first to third back inner wires 102a, 102b, and 102c may extend in the horizontal direction (the X direction and/or the Y direction) to surround the main chip region MC. According to some example embodiments, the back inner via 103 may extend in the vertical direction (the Z direction) and connect the first back inner wire 102a to the second back inner wire 102b and the second back inner wire 102b to the third back inner wire 102c.

According to some example embodiments, the back outer ring structure BR2 may include first to third back outer wires 104a, 104b, and 104c, which are sequentially stacked in a direction away from the second surface 110B of the semiconductor substrate 110, and a back outer via 105. According to some example embodiments, the first to third back outer wires 104a, 104b, and 104c may extend in the horizontal direction (the X direction and/or the Y direction) to surround the back inner ring structure BR1. According to some example embodiments, the back outer via 105 may extend in the vertical direction (the Z direction) and connect the first back outer wire 104a to the second back outer wire 104b and the second back outer wire 104b to the third back outer wire 104c.

In some example embodiments, each of the first to third back inner wires 102a, 102b, and 102c may be coplanar or substantially coplanar with a corresponding back outer wire among the first to third back outer wires 104a, 104b, and 104c, and a corresponding back wiring layer among the first to third back wiring layers PWL1, PWL2, and PWL3.

In some example embodiments, the back ring structure BR may be formed together with the power wiring structure PWS in a process of forming the power wiring structure PWS in the main chip region MC. Accordingly, the back ring structure BR may be formed by an existing semiconductor manufacturing process that forms the power wiring structure PWS, without introducing an additional process.

According to some example embodiments, the back ring structure BR may include Co, W, Cu, Ru, Mn, Ti, Ta, TiN, TaN, or a combination thereof but is not limited thereto.

According to some example embodiments, in a plan view, the back inner ring structure BR1 and the back outer ring structure BR2 may respectively have concentric closed loop shapes. According to some example embodiments, the back inner ring structure BR1 and the back outer ring structure BR2 may be separated by the back insulating structure PWI from each other in the horizontal direction (the X direction and/or the Y direction).

According to some example embodiments, the back ring structure BR may be arranged in a back side of the semiconductor device 100 to protect the main chip region MC from external factors occurring during a die sawing process. For example, the back inner ring structure BR1 may prevent or reduce a crack, which occurs in the back side of the semiconductor device 100 during a die sawing process, from propagating to the main chip region MC. For example, the back outer ring structure BR2 may prevent or reduce moisture from penetrating into the main chip region MC through a crack occurring in the back side of the semiconductor device 100.

Here, each of the front inner ring structure FR1 and the back inner ring structure BR1 may be referred to as a guard ring, and each of the front outer ring structure FR2 and the back outer ring structure BR2 may be referred to as a moisture barrier ring.

In the case of a three-dimensional (3D) semiconductor chip having a wiring structure on each of the front and back sides of a semiconductor substrate, damage to a main chip region may occur due to an external impact like a die sawing process. The semiconductor device 100 may have a dual-ring structure, in which the front ring structure FR and the back ring structure BR are respectively arranged on the front and back sides of the semiconductor substrate 110 in the sealing region MS. According to some example embodiments, because the semiconductor device 100 includes the front ring structure FR and the back ring structure BR respectively on both sides of the semiconductor substrate 110, a crack or moisture occurring due to an external factor may be effectively prevented or reduced from propagating to the main chip region MC.

According to some example embodiments, the front ring structure FR and the back ring structure BR may at least partially overlap with each other in the vertical direction (the Z direction). According to some example embodiments, the front inner ring structure FR1 may overlap with the back inner ring structure BR1 in the vertical direction (the Z direction). According to some example embodiments, the front outer ring structure FR2 may overlap with the back outer ring structure BR2 in the vertical direction (the Z direction). According to some example embodiments, in a plan view, the main chip region MC may be surrounded by the front and back inner ring structures FR1 and BR1 and the front and back outer ring structures FR2 and BR2, which are concentrically arranged in the sealing region MS.

Although it is illustrated in FIG. 2 that each of the front and back inner ring structures FR1 and BR1 and the front and back outer ring structures FR2 and BR2 has a rectangular shape in a plan view, example embodiments are not limited thereto. For example, each of the front and back inner ring structures FR1 and BR1 and the front and back outer ring structures FR2 and BR2 may have a circular shape or a polygonal shape other than a rectangular shape. Although it is illustrated in FIG. 2 that each of the front and back inner ring structures FR1 and BR1 and the front and back outer ring structures FR2 and BR2 has a straight line shape extending long in a plan view, example embodiments are not limited thereto. For example, each of the front and back inner ring structures FR1 and BR1 and the front and back outer ring structures FR2 and BR2 may have a rounded curve shape or a line shape extending in zigzag.

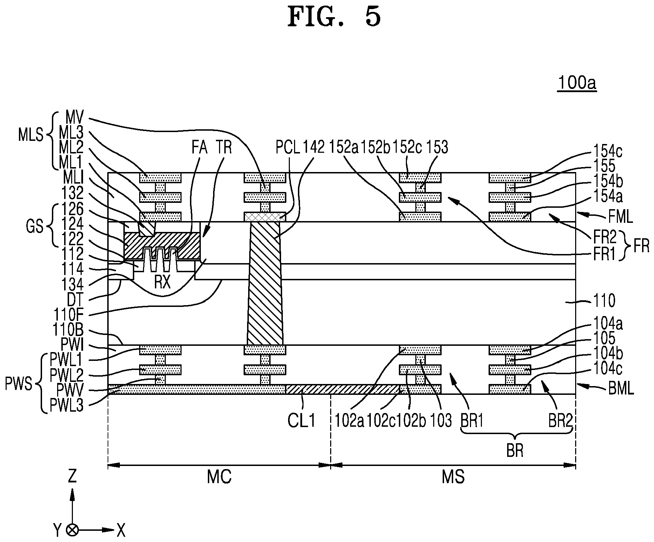

FIG. 5 is a schematic cross-sectional view of a semiconductor device 100a having the plan view of FIG. 2, according to some example embodiments, and is a vertical cross-sectional view illustrating a portion corresponding to FIG. 3. FIG. 5 is different from FIG. 3 in that the semiconductor device 100a further includes a first connection wire CL1 connecting the power wiring structure PWS to the back inner ring structure BR1.

Referring to FIG. 5, the first connection wire CL1 connecting the power wiring structure PWS to the back inner ring structure BR1 may be arranged in the back wiring layer BML. According to some example embodiments, the first connection wire CL1 may be in the boundary between the main chip region MC and the sealing region MS. For example, an end of the first connection wire CL1 may be in the main chip region MC and connected to the power wiring structure PWS, and an opposite end of the first connection wire CL1 may be in the sealing region MS and connected to the back inner ring structure BR1. According to some example embodiments, the back inner ring structure BR1 may be grounded through the power wiring structure PWS connected thereto through the first connection wire CL1. Accordingly, charges accumulated in the back inner ring structure BR1 may be discharged, and external static electricity may be prevented from affecting or having a reduced effect on the main chip region MC.

According to some example embodiments, the first connection wire CL1 may include Co, W, Cu, Ru, Mn, Ti, Ta, TiN, TaN, or a combination thereof but is not limited thereto.

In some example embodiments, the first connection wire CL1 may have an integral structure (for example, directly connected with, formed of joined materials, or the like) with the back inner ring structure BR1 and the power wiring structure PWS. For example, the first connection wire CL1 may be formed together with the back inner ring structure BR1 in a process of forming the back inner ring structure BR1. In some example embodiments, the first connection wire CL1 may be formed in an additional plating process after the back inner ring structure BR1 is formed.

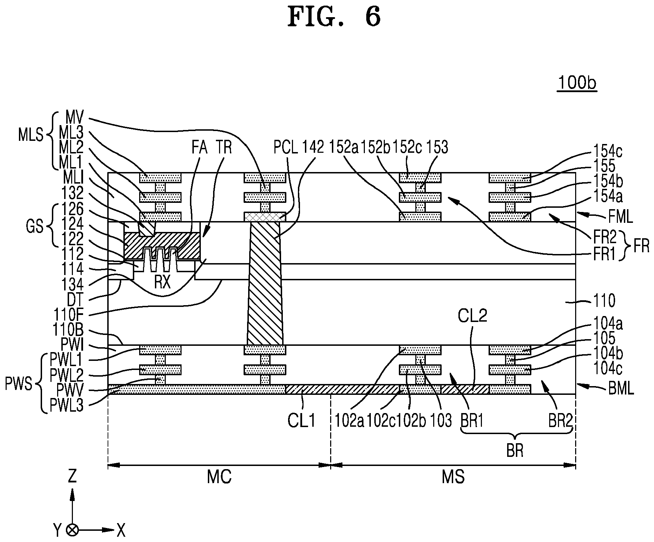

FIG. 6 is a schematic cross-sectional view of a semiconductor device 100b having the plan view of FIG. 2, according to some example embodiments, and is a vertical cross-sectional view illustrating a portion corresponding to FIG. 3. FIG. 6 is different from FIG. 5 in that the semiconductor device 100b further includes a second connection wire CL2 connecting the back inner ring structure BR1 to the back outer ring structure BR2.

Referring to FIG. 6, the second connection wire CL2 connecting the back inner ring structure BR1 to the back outer ring structure BR2 may be arranged in the back wiring layer BML in the sealing region MS. For example, an end of the second connection wire CL2 may be in contact with the back inner ring structure BR1, and an opposite end of the second connection wire CL2 may be in contact with the back outer ring structure BR2. According to some example embodiments, the second connection wire CL2 may have an integral structure (for example, directly connected with, formed of joined materials, or the like) with the back inner ring structure BR1 and the back outer ring structure BR2.

According to some example embodiments, the second connection wire CL2 may include Co, W, Cu, Ru, Mn, Ti, Ta, TiN, TaN, or a combination thereof but is not limited thereto.

For example, the second connection wire CL2 may be formed together with the back inner ring structure BR1 and the back outer ring structure BR2 in a process of forming the back inner ring structure BR1 and the back outer ring structure BR2.

According to some example embodiments, the back outer ring structure BR2 may be connected to the power wiring structure PWS through the second connection wire CL2 and the first connection wire CL1 and thus be grounded. Accordingly, the back outer ring structure BR2 may be prevented or reduced from being damaged by charged particles generated in an etching process using plasma.

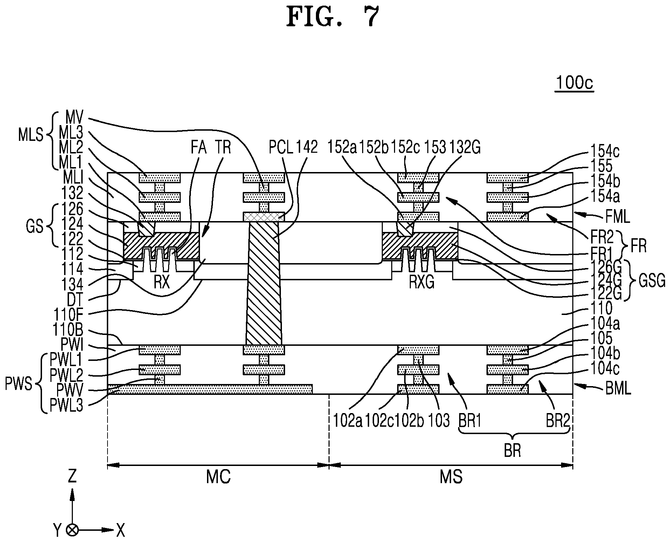

FIG. 7 is a schematic cross-sectional view of a semiconductor device 100c having the plan view of FIG. 2, according to some example embodiments, and is a vertical cross-sectional view illustrating a portion corresponding to FIG. 3. FIG. 7 is different from FIG. 3 in that the semiconductor device 100c further includes an outer gate structure GSG on the first surface 110F of the semiconductor substrate 110 in the sealing region MS.

Referring to FIG. 7, in the sealing region MS, an outer active region RXG including a plurality of fin-type active regions FA may be arranged on the first surface 110F of the semiconductor substrate 110, and the outer gate structure GSG may be arranged on the outer active region RXG. The outer active region RXG and the outer gate structure GSG in the sealing region MS may have the similar structure as the active region RX and the gate structure GS in the main chip region MC, which have been described with reference to FIG. 3. For example, the outer gate structure GSG may include a gate dielectric film 122G, a gate electrode 124G, and a gate capping layer 126G. In the current context, the term "outer" in "outer active region RXG" and "outer gate structure GSG" may refer to a relative position (e.g. a horizontal position relative to the main chip region MC). For instance, the "outer active region RXG" and "outer gate structure GSG" may be located in the sealing region MS, outside the main chip region MC.

According to some example embodiments, the front inner ring structure FR1 may be on the outer gate structure GSG and connected to the gate electrode 124G of the outer gate structure GSG through an outer gate contact 132G, which passes through the gate capping layer 126G. For example, the bottom surface of the outer gate contact 132G may be in contact with the gate electrode 124G, and the top surface of the outer gate contact 132G may be in contact with the front inner ring structure FR1. According to some example embodiments, the front inner ring structure FR1 may be connected to the outer active region RXG through the outer gate contact 132G and the gate electrode 124G and thus be grounded. Accordingly, charges accumulated in the front inner ring structure FR1 may be discharged so that the main chip region MC may be protected from the external static electricity or electromagnetic interference.

In some example embodiments, the outer active region RXG, the outer gate structure GSG, and the outer gate contact 132G in the sealing region MS may be formed in a process of forming the active region RX, the gate structure GS, and the gate contact 132 in the main chip region MC.

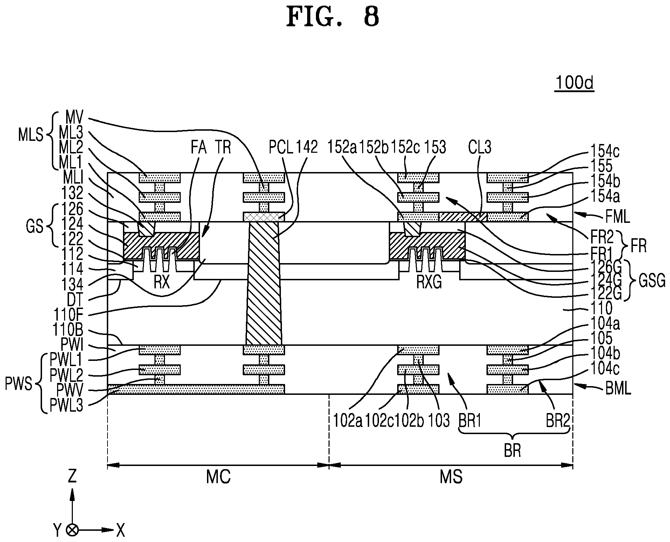

FIG. 8 is a schematic cross-sectional view of a semiconductor device 100d having the plan view of FIG. 2, according to some example embodiments, and is a vertical cross-sectional view illustrating a portion corresponding to FIG. 3. FIG. 8 is different from FIG. 7 in that the semiconductor device 100d further includes a third connection wire CL3 connecting the front inner ring structure FR1 to the front outer ring structure FR2.

Referring to FIG. 8, in the sealing region MS, the third connection wire CL3 connecting the front inner ring structure FR1 to the front outer ring structure FR2 may be arranged in the front wiring layer FML. For example, an end of the third connection wire CL3 may be in contact with the front inner ring structure FR1, and an opposite end of the third connection wire CL3 may be in contact with the front outer ring structure FR2. According to some example embodiments, the third connection wire CL3 may have an integral structure (for example, directly connected with, formed of joined materials, or the like) with the front inner ring structure FR1 and the front outer ring structure FR2.

According to some example embodiments, the third connection wire CL3 may include Co, W, Cu, Ru, Mn, Ti, Ta, TiN, TaN, or a combination thereof but is not limited thereto.

For example, the third connection wire CL3 may be formed together with the front inner ring structure FR1 and the front outer ring structure FR2 in a process of forming the front inner ring structure FR1 and the front outer ring structure FR2.

For example, the third connection wire CL3 may provide a ground path for the front outer ring structure FR2, and accordingly, the front outer ring structure FR2 may be prevented from being damaged or have reduced damage by charged particles generated in an etching process using plasma. For example, the front outer ring structure FR2 may be connected to the outer active region RXG through the third connection wire CL3, the outer gate contact 132G, and the gate electrode 124G and thus be grounded.

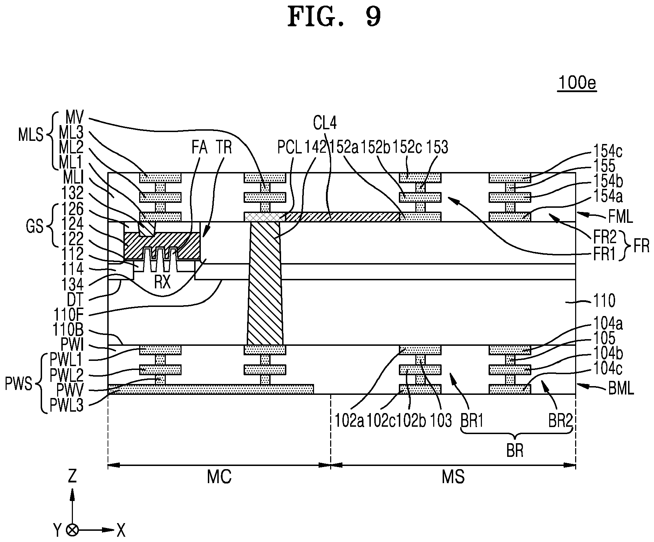

FIG. 9 is a schematic cross-sectional view of a semiconductor device 100e having the plan view of FIG. 2, according to some example embodiments, and is a vertical cross-sectional view illustrating a portion corresponding to FIG. 3. FIG. 9 is different from FIG. 3 in that the semiconductor device 100e further includes a fourth connection wire CL4 connecting the front wiring structure MLS to the front inner ring structure FR1.

Referring to FIG. 9, the fourth connection wire CL4 connecting the front wiring structure MLS to the front inner ring structure FR1 may be arranged in the front wiring layer FML. According to some example embodiments, the fourth connection wire CL4 may be in the boundary between the main chip region MC and the sealing region MS. For example, an end of the fourth connection wire CL4 may be in the main chip region MC and connected to the front wiring structure MLS, and an opposite end of the fourth connection wire CL4 may be in the sealing region MS and connected to the front inner ring structure FR1.

According to some example embodiments, the end of the fourth connection wire CL4 may be connected to the power connection conductive layer PCL of the main chip region MC and thus provide a ground path for the front inner ring structure FR1. According to some example embodiments, the power wiring structure PWS on the second surface 110B of the semiconductor substrate 110 in the main chip region MC may apply a power supply voltage and/or a ground voltage to the front inner ring structure FR1 in the sealing region MS through the power through via 142, the power connection conductive layer PCL of the front wiring structure MLS, and the fourth connection wire CL4.

According to some example embodiments, the fourth connection wire CL4 may include Co, W, Cu, Ru, Mn, Ti, Ta, TiN, TaN, or a combination thereof but is not limited thereto.

In some example embodiments, the fourth connection wire CL4 may have an integral structure (for example, directly connected with, formed of joined materials, or the like) with the front inner ring structure FR1 and the front wiring structure MLS. For example, the fourth connection wire CL4 may be formed together with the front inner ring structure FR1 in a process of forming the front inner ring structure FR1.

Although FIG. 5 shows that the back inner ring structure BR1 is connected to the power wiring structure PWS through the first connection wire CL1 and, separately, FIG. 9 shows that the front inner ring structure FR1 is connected to the power connection conductive layer PCL of the front wiring structure MLS through the fourth connection wire CL4, example embodiments are not limited thereto. For example, the front inner ring structure FR1 may be electrically connected to the front wiring structure MLS through the fourth connection wire CL4, and/or the back inner ring structure BR1 may be electrically connected to the power wiring structure PWS through the first connection wire CL1. In this case, a power supply voltage or a ground voltage may be applied from the power wiring structure PWS to each of the front inner ring structure FR1 and the back inner ring structure BR1. Furthermore, various combinations of the connection wires and/or outer gate structure GSG of FIGs. 5-9 may be implemented to ground one or more of the front inner ring structure FR1, the front outer ring structure FR2, the back inner ring structure BR1 and the back outer ring structure BR2.

Unlike a semiconductor device having a wiring structure on only one surface of a semiconductor substrate, in the case of a semiconductor device having a 3D structure having wiring structures respectively on both surfaces of a semiconductor substrate, packaging complexity increases, and accordingly, defects in the semiconductor device due to a crack occurring in a die sawing process intensify. According to the inventive concepts, the semiconductor device 100 may include the front and back ring structures FR and BR respectively on the first and second surfaces 110F and 110B of the semiconductor substrate 110, thereby preventing or reducing the main chip region MC from being damaged during a die sawing process.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

While the inventive concepts have been particularly shown and described with reference to some example embodiments thereof, it will be understood that various changes in form and details may be made therein without departing from the scope of the following claims.

## Claims

1. A semiconductor device comprising:
a semiconductor substrate having a first surface and a second surface facing away from the first surface and including, in a plan view, a main chip region and a sealing region surrounding the main chip region;
a front wiring layer on the first surface of the semiconductor substrate and including a front wiring structure;
a back wiring layer on the second surface of the semiconductor substrate and including a power wiring structure;
a front ring structure in the front wiring layer of the sealing region; and
a back ring structure in the back wiring layer of the sealing region.

2. The semiconductor device of claim 1, wherein the back ring structure is connected to the power wiring structure.

3. The semiconductor device of claim 1 or claim 2, further comprising an outer gate structure on the first surface of the semiconductor substrate of the sealing region,
wherein the front ring structure is on and connected to the outer gate structure.

4. The semiconductor device of any preceding claim, wherein the front ring structure is connected to the front wiring structure.

5. The semiconductor device of any preceding claim, wherein the front ring structure at least partially overlaps with the back ring structure in a vertical direction.

6. The semiconductor device of any preceding claim, wherein each of the front ring structure and the back ring structure has a closed loop shape.

7. The semiconductor device of any preceding claim, further comprising a power through via passing through the semiconductor substrate,
wherein the power through via is connected to the front wiring structure and the power wiring structure.

8. The semiconductor device of claim 7, wherein
the front wiring structure includes a power connection conductive layer on the power through via, the power connection conductive layer being connected to the power through via, and
the front ring structure is connected to the power connection conductive layer.

9. The semiconductor device of any preceding claim, wherein
the back ring structure includes:
a back inner ring structure surrounding the main chip region; and
a back outer ring structure surrounding the back inner ring structure, and
the back inner ring structure is separated from the back outer ring structure in a horizontal direction.

10. The semiconductor device of any of claims 1-8, wherein
the back ring structure includes:
a back inner ring structure surrounding the main chip region; and
a back outer ring structure surrounding the back inner ring structure, and
the back outer ring structure is connected to the back inner ring structure.

11. A semiconductor device of any of claims 1-8, wherein:
the front wiring structure is in the main chip region;
the power wiring structure is in the main chip region;
the front ring structure includes, in a plan view, a front inner ring structure surrounding the main chip region and a front outer ring structure surrounding the front inner ring structure, and
the back ring structure includes, in a plan view, a back inner ring structure surrounding the main chip region and a back outer ring structure surrounding the back inner ring structure.

12. The semiconductor device of claim 11, further comprising a first connection wire in the back wiring layer in a boundary between the main chip region and the sealing region,
wherein the back inner ring structure is connected to the power wiring structure through the first connection wire.

13. The semiconductor device of claim 12, further comprising a second connection wire in the back wiring layer of the sealing region, the second connection wire being configured to connect the back outer ring structure to the back inner ring structure.

14. The semiconductor device of any of claims 11-13, further comprising:
an outer gate structure on the first surface of the semiconductor substrate in the sealing region; and
a third connection wire in the front wiring layer of the sealing region, the third connection wire being configured to connect the front outer ring structure to the front inner ring structure,
wherein the front inner ring structure is on and connected to the outer gate structure.

15. The semiconductor device of any of claims 11-14, further comprising:
a power through via passing through the semiconductor substrate; and
a fourth connection wire in the front wiring layer in a boundary between the main chip region and the sealing region,
wherein the front wiring structure is connected to the power wiring structure through the power through via, and
the front inner ring structure is connected to the front wiring structure through the fourth connection wire.
